# FASCICULE DE BREVET EUROPEEN

(11) **EP 1 015 247 B1**
(45) Date de publication et mention de la délivrance du brevet: **21.08.2002**
(21) Numéro de dépôt: 98943976.5
(22) Date de dépôt: 14.09.1998
(51) Int. Cl.: B41F 15/36, H05K 3/12

(54) **MINI POCHOIR ET SON DISPOSITIF DE MISE EN OEUVRE**
MINISCHABLONE UND VORRICHTUNG ZU DEREN ANWENDUNG
MINI-STENCIL AND DEVICE FOR USING SAME

(30) Priorité: 16.09.1997 FR 9711507; 03.12.1997 FR 9715415; 07.05.1998 FR 9805777
(43) Date de publication de la demande: 05.07.2000
(73) Titulaire: Societe Novatec S.A., 82000 Montauban (FR)
(72) Inventeur: BOURRIERES, Francis, F-82000 Montauban (FR); KAISER, Clément, F-82000 Montauban (FR)
(86) Numéro de dépôt international: FR9801957
(87) Numéro de publication internationale: WO99014049

(56) Documents cités:
- DE-A- 4 239 995
- FR-A- 2 722 138

## Description

La présente invention concerne un mini pochoir de réparation et/ou de remplacement de composants unitaires ou de groupes de composants sur une carte électronique et son dispositif de mise en oeuvre. Ledit pochoir permettant de déposer de la crème à braser, du flux ou de la colle conductrice.

Il peut apparaître nécessaire en cours de fabrication, suite à des contrôles ou après fabrication de remplacer un composant défectueux ou d'ajouter un ou plusieurs composants manquants.
Dans ce cas, il est nécessaire de déposer du flux et/ou de la crème à braser sur les plages d'accueil des composants concernés.

En fonction de la configuration de la carte et de la disposition des différents composants, l'accès aux plages d'accueil concernées n'est pas toujours facile.

La technique connue propose des micro-pochoirs métalliques, soit avec support central, soit avec support latéral sur deux côtés ou trois côtés. Ces micro-pochoirs métalliques présentent un certain nombre d'inconvénients.
Avec ce type de pochoir, il n'est pas possible de s'approcher à moins de deux millimètres d'un autre composant situé dans l'environnement immédiat des plages d'accueil à traiter ; même lorsque l'on y parvient, il est impossible d'éviter lors de l'opération de sérigraphie au moyen d'une mini-racle les débordements de crème à braser hors du micro-pochoir.

Ces micro-pochoirs utilisent la rigidité du métal car ils ne peuvent être tendus. La tension étant nulle, ces pochoirs ne sont que très rarement parfaitement en contact sur la surface de la carte et la sérigraphie est de ce fait imparfaite.

Avec le pochoir métallique, pour avoir une rigidité suffisante, il faut une certaine épaisseur minimum du pochoir.
Cette nécessaire épaisseur ou épaisseur minimale pose problème pour la sérigraphie des pas fins, la largeur d'ouverture minimale acceptable étant de une fois et demie l'épaisseur afin de pouvoir démouler les plots.

En fait, avec les pochoirs métalliques connus utilisés à cet usage, il est difficile d'atteindre le pas de 0,635 mm.

Le pochoir selon l'invention permet de rendre la tension du pochoir indépendante de son épaisseur, ce qui permet d'adopter une épaisseur permettant de parvenir à un pas de 0,4 mm.

La rigidité du micro-pochoir métallique nécessaire pour obtenir une stabilité suffisante du pochoir ne permet pas de le conformer de sorte à ce qu'il soit parfaitement en contact avec les circuits à réparer ou à compléter. De plus les circuits étant déjà équipés de composants de formes et de dimensions très variées, il est nécessaire de réaliser des montages de positionnement des circuits sur la table support utilisés pour obtenir le parallélisme du pochoir et du circuit.
A défaut d'y procéder, ce qui est fastidieux, la sérigraphie sera imparfaite voire complètement défectueuse.
De plus, le positionnement visuel des micro-pochoirs métalliques sur les plages d'accueil qui ne peut se faire que par repérage à travers ses ouvertures est particulièrement long.

Le document DE4239995 A décrit un dispositif de sérigraphie sélective comprenant un pochoir et son dispositif de mise en oeuvre. Dans ce document le pochoir est monté sur un élément fixe qui forme un caisson rigide.

Le document FR2722138A décrit un pochoir en matériau synthétique. Le matériau synthétique présente selon ce document un certain nombre d'avantages par rapport à des pochoirs métalliques dont en particulier son élasticité. L'élasticité permet de réaliser une sérigraphie hors contact c'est-à-dire que le pochoir n'est pas en contact intime avec le substrat, mais c'est la racle lors de son passage qui va appuyer le pochoir contre le substrat. Au fur et à mesure que la racle avance, les dépôts sont démoulés grâce à ce hors contact La technique décrite dans ce document est particulièrement adaptée au dosage de produit visqueux selon des hauteurs variables. La présente invention vise à obvier à ces inconvénients en réalisant d'une part, un pochoir associé à un élément de mise en tension indépendant de son épaisseur permettant le dépôt de flux ou de crème à braser ou de colle conductrice sur les plages d'accueil relatives à un composant ou à un groupe de composants sans qu'il y ait de débordement de produit hors du pochoir, le positionnement de celui-ci étant par ailleurs facilité du fait de sa conception, d'autre part d'associer le pochoir à un dispositif de mise en oeuvre du dit pochoir qui permette de positionner le pochoir rapidement et en contact parfait avec la carte et quel que soit l'environnement des plages d'accueil concernées ou la composition de cette carte, tout type de composant étant accessible au pochoir selon l'invention. Le pochoir selon l'invention est souple et peut se mouvoir dans l'espace selon les 6 degrés de liberté. Ainsi ce pochoir peut remplir l'ensemble des fonctions auxquelles il est destiné.

A cet effet, le pochoir selon l'invention permettant de déposer de la crème à braser ou du flux ou des colles conductrices sur des zones d'accueil pour la réparation et/ou le remplacement et/ou la pose de composants sur une carte électronique se caractérise essentiellement en ce qu'il comprend :
- une feuille plane de forme rectangulaire en matériau synthétique souple ou métallique dotée d'orifices de transfert pour la distribution de produit en quantité constante correspondant aux plages d'accueil et aux pattes des composants ;
- deux des côtés parallèles de la feuille sont reliés à des pattes perpendiculaires à la feuille, rigides et mobiles en position de fixation de la feuille sur un élément support et de mise en tension de la feuille ;
- les deux autres côtés parallèles de la feuille sont prolongés par des bavettes souples, un pli raidisseur et d'articulation séparant la feuille perforée et chacune des bavettes souples, le dit pli délimitant la feuille, la bavette étant libre en rotation autour du dit pli.
Suivant une autre caractéristique de l'invention, le pochoir forme une enceinte dotée d'un fond souple avec orifices et qui est ouverte vers le haut et accessible par le haut ou par deux de ses côtés ou au moins un.

Suivant une autre caractéristique, la feuille constituant le pochoir est demi-transparente ou translucide.

Suivant encore une autre caractéristique de l'invention, les bavettes souples orthogonales à la feuille sont libres par rapport aux autres côtés de la feuille reliés aux pattes de fixation.

Suivant encore une autre caractéristique de l'invention, l'élément de mise en tension du pochoir selon l'invention auquel le pochoir est fixé par une aile parallèle à la feuille de chacune de ses pattes rigides perpendiculaires à la feuille comprend:
- un axe de tension du pochoir par écartement ou rapprochement des pattes, parallèle au pochoir,
- un axe de guidage en translation du support parallèle au pochoir visant à tendre le pochoir ;
- un axe de rotation de chacune des pattes parallèle au pochoir;
- un axe de rotation de chacune des pattes perpendiculaire au pochoir, ce qui permet de toujours positionner et conformer localement le pochoir en fonction de la position de la carte en sorte qu'il soit étroitement appliqué en tension sur celle-ci même si la carte est voilée.

Un dispositif de mise en oeuvre formé par un bras articulé permet au pochoir d'atteindre une position quelconque dans l'espace.

D'autres avantages et caractéristiques de l'invention apparaîtront à la lecture de la description d'une forme préférée de réalisation de l'invention illustrée par les dessins joints donnés à titre d'exemples non limitatifs et dans lesquels :
- la figure 1 est une vue en perspective d'un pochoir unitaire selon l'invention ;
- la figure 2 est une vue d'une forme de réalisation de l'élément de mise en tension du pochoir.
- la figure 3 est une vue d'une forme de réalisation d'un dispositif formant un bras articulé pour la mise en oeuvre du pochoir dans une région quelconque de l'espace; l'ensemble pouvant se mouvoir selon les 6 degrés de liberté.
- la figure 4 est une vue d'une autre forme de réalisation d'un dispositif formant un portique pour la mise en oeuvre du pochoir dans une région quelconque de l'espace ; l'ensemble pouvant se mouvoir selon les six degrés de liberté.

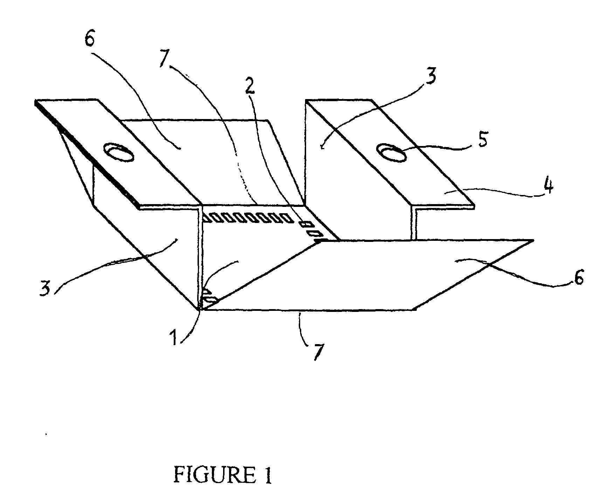

Tel que représenté en figure 1, le pochoir selon l'invention comprend une feuille 1 plane de forme rectangulaire en matériau synthétique souple ou métallique dotée d'orifices 2 de transfert et de distribution de produit. Avantageusement, les dimensions de la feuille et la position des ouvertures correspondent à un type de composant, les orifices 2 correspondant à la position et à la forme des plages d'accueil du dit composant.
Il peut arriver qu'il soit nécessaire de traiter simultanément un groupe de composants identiques ou différents situés les uns à côté des autres ; dans ce cas le pochoir aura une dimension adaptée à la globalité à traiter.

Dans le brevet français FR2722138 du même inventeur, le but recherché était le dosage du produit transféré de façon à avoir des plots déposés de hauteur différente avec une même épaisseur de pochoir.
Pour cela, il était obligatoirement nécessaire d'avoir des orifices circulaires et de diamètres différents et variables de l'un à l'autre en fonction des hauteurs choisies pour les plots. Dans cette application chaque ouverture se comporte comme un réservoir qui se vide plus ou moins.
Dans le cas du présent pochoir, objet de la demande et du brevet qui en découle, les orifices ne sont pas forcément circulaires mais sont dans tous les cas identiques entre eux pour un même composant et dans tous les cas l'épaisseur du pochoir est adaptée de façon à ce que chaque ouverture se vide complètement et non partiellement.

La feuille 1 est une feuille souple présentant une résistance mécanique suffisante pour être mise en tension et résistante aux agents chimiques.
Un matériau tel que le polyester est particulièrement adapté à cet usage.
Dans certains cas, l'utilisation de la feuille métallique peut s'avérer aussi judicieuse.

Dans la présente invention, le matériau utilisé peut être le même que dans le brevet FR2722138 pour des raisons cependant différentes.
Dans le brevet FR2722138, il est fait usage des caractéristiques d'extensibilité pour obtenir du hors contact en aval et en amont de la racle.

Dans la présente invention, le hors contact n'est pas souhaité, il est même supprimé ; c'est la souplesse du matériau qui est utilisée pour obtenir un contact étroit entre toute la surface du pochoir et celle de la carte ou du circuit même si cette surface est voilée ; en fait on cherche à conformer le pochoir au substrat. Pour cela, la souplesse du pochoir se combine comme décrit plus loin, avec les axes de rotation de l'élément de mise en tension.

Deux des côtés parallèles de la feuille sont reliés ou fixés sur des pattes 3 rigides.
Chaque patte présente une partie perpendiculaire au mini-pochoir ou la feuille dont la largeur est égale à la dimension du côté de la feuille et une aile 4 perpendiculaire à la précédente avec un perçage 5 médian de fixation à l'élément de mise en tension.
Les pattes 3 réalisent la fonction de raidisseur de la feuille et permettent sa mise en tension.

La hauteur des pattes est différente d'un pochoir à l'autre en fonction de celle des composants qui sont à proximité.
Cette hauteur de patte peut être variable pour un même pochoir et réglable à volonté en fonction de la hauteur des composants de proximité.

Les deux autres côtés de la feuille sont chacun prolongés par une paroi ou bavette souple 6, un pli raidisseur 7 séparant la feuille 1 et chacune des parois et délimitant la feuille, la paroi 6 étant libre en rotation autour du pli raidisseur 7.

Ces dispositions réalisent un pochoir formant une enceinte dotée d'un fond souple avec orifices 2 et qui est ouverte vers le haut et accessible par le haut ou par deux de ses côtés ou au moins l'un des deux si une paroi est libre. En effet, les deux pattes ainsi que les deux parois souples constituent des limites physiques qui empêchent les débordements de produit à sérigraphier sur le substrat.

Cette disposition de l'invention permet à la fois de raidir la feuille dans la zone non maintenue par les pattes et d'éviter que la crème ne soit répandue au-delà de celle-ci.
Cette disposition de l'invention permet d'utiliser une racle dont la largeur est celle du pochoir, ce qui permet de réaliser la sérigraphie par un seul passage de la racle. L'utilisation d'une racle dont la largeur correspond à celle du pochoir permet d'obtenir la mise en rotation de la crème sur le pochoir, ce qui a pour effet en utilisant les capacités de thixotropie de la crème, de réaliser une homogénéisation de la crème en évitant de désorganiser sa structure par cisaillage et oxydation et de la fluidifier.
Sur les micro-pochoirs existants, notamment lorsque leur fixation est centrale, il est nécessaire d'effectuer le raclage en plusieurs fois. Cela entraîne la réalisation de dépôts irréguliers en particulier si le pochoir n'est pas étroitement appliqué sur le substrat ; avec la présente invention, il est possible de racler la surface du circuit (le substrat) correspondant au composant en un seul passage puisque aucun obstacle ne se présente dans la direction du raclage et de plus, les parois verticales souples 6 ou bavettes arrêtent le produit en début et en fin de raclage.

Le dispositif de mise en oeuvre du pochoir selon l'invention permet de déplacer ce dernier avec des mouvements de grande amplitude suivant les six degrés de liberté de l'espace.
Il est ainsi possible grâce à l'invention d'accéder et de sérigraphier des substrats dans une position stabilisée quelconque de l'espace, ce qui apporte les avantages suivants :
- le positionnement du substrat n'est plus nécessaire,
- il devient possible d'effectuer avec facilité des sérigraphies sur des cartes équipées d'autres composants,
- il devient possible de faire des sérigraphies sur des cartes qui sont contenues dans un boîtier ou sur une pièce en trois dimensions.
L 'invention est particulièrement adaptée à la sérigraphie sélective.

La sérigraphie est dite sélective lorsqu'il faut réparer un circuit et remplacer un composant ; dans ce cas, il est fait usage de micro-pochoirs. Cependant, il va de soi que l'invention n'est pas limitée à ce cas mais s'applique plus généralement à des cas où la sérigraphie est à réaliser sur les zones difficiles d'accès d'un substrat.

Le problème de l'utilisation de micro-pochoirs est qu'ils doivent s'adapter étroitement à la conformation du substrat dans la zone concernée par la sérigraphie sélective.

Cette conformation est difficile à obtenir avec les micro-pochoirs métalliques utilisés dans l'art antérieur. Ces pochoirs sont fixés sur un axe support vertical médian ou excentré à leur surface, ce qui rend la sérigraphie difficile et ne permet pas toujours de les plaquer étroitement sur le substrat, ce qui ne permet pas d'obtenir une sérigraphie satisfaisante : plats imparfaits ou mal placés, incapacité de réaliser des pas fins, etc....

La présente invention permet à la fois de mouvoir le pochoir dans toutes les positions de l'espace, de le conformer au substrat, de rechercher en une seule fois la position idéale du pochoir selon les six degrés de liberté dans l'espace en réalisant un contact étroit entre pochoir et substrat et d'autre part de retrouver la position idéale lorsqu'on doit faire une autre opération de sérigraphie sur un même substrat.

A cet effet, le dispositif selon l'invention de réalisation de sérigraphie en des zones déterminées et délimitées d'un substrat et ce quelle que soit la position stable ou stabilisée de celui-ci ou la conformation dans toutes les dimensions de l'environnement de la ou des zones du substrat sur lequel la sérigraphie doit être effectuée, ledit dispositif comportant un pochoir de dimensions adaptées à la sérigraphie à réaliser, ledit pochoir étant tendu sur un support se caractérise essentiellement en ce que le pochoir et son tendeur sont fixés sur un dispositif ou organe autorisant leur libre déplacement en sorte que le pochoir puisse être amené et plaqué sur ledit substrat à la zone où la sérigraphie est à réaliser et ce quelle que soit la position et la forme du substrat concerné, en ce que la position de l'organe est blocable, en sorte que le pochoir et son support sont bloqués en position pour réaliser la sérigraphie et qu'ils peuvent être écartés du substrat pour son évacuation et/ou son remplacement et retrouver la position de sérigraphie par déplacement en sens inverse, l'écartement ou le rapprochement du pochoir s'effectuant de manière orthogonale ou sensiblement orthogonale par rapport au substrat.

Suivant une disposition de l'invention, l'organe ou dispositif de mise en oeuvre est un bras à plusieurs brins articulés, doté d'un moyen de blocage unique de sa ou de ses articulations, ledit bras portant à une de ses extrémités le support sur lequel est tendu le pochoir et son autre extrémité étant fixée.

Suivant une autre disposition de l'invention, l'organe de mise en oeuvre est un portique.

Le dispositif de mise en oeuvre permet au pochoir selon l'invention d'avoir un mouvement quelconque dans l'espace.

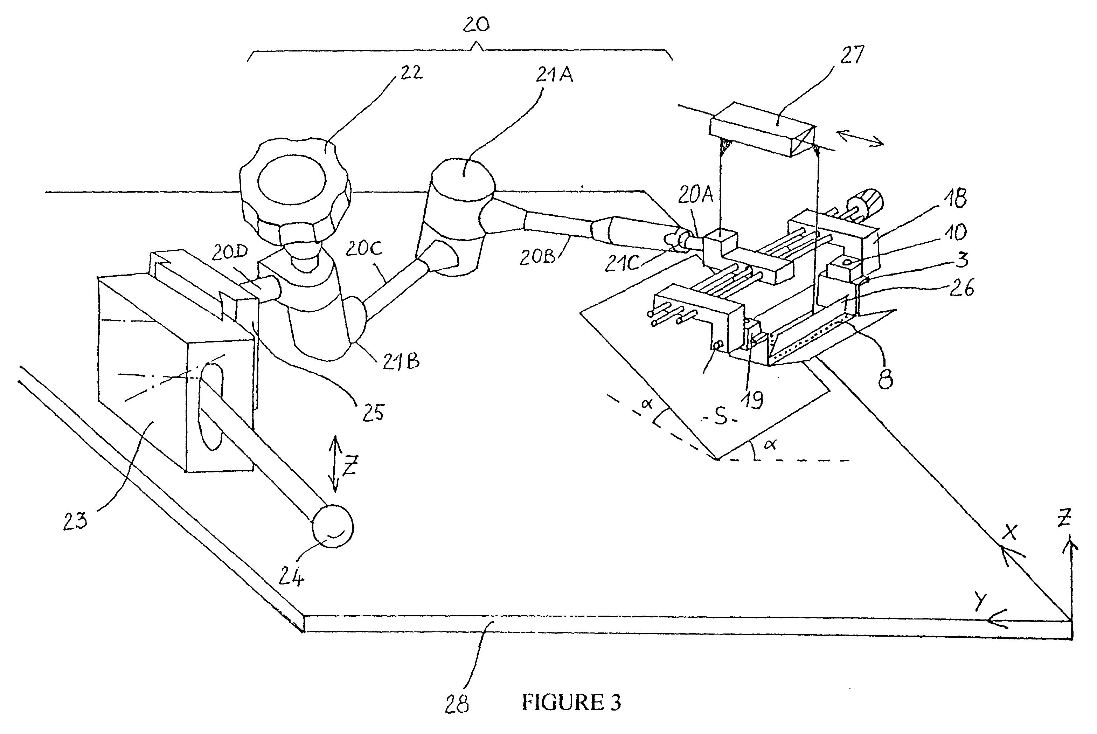

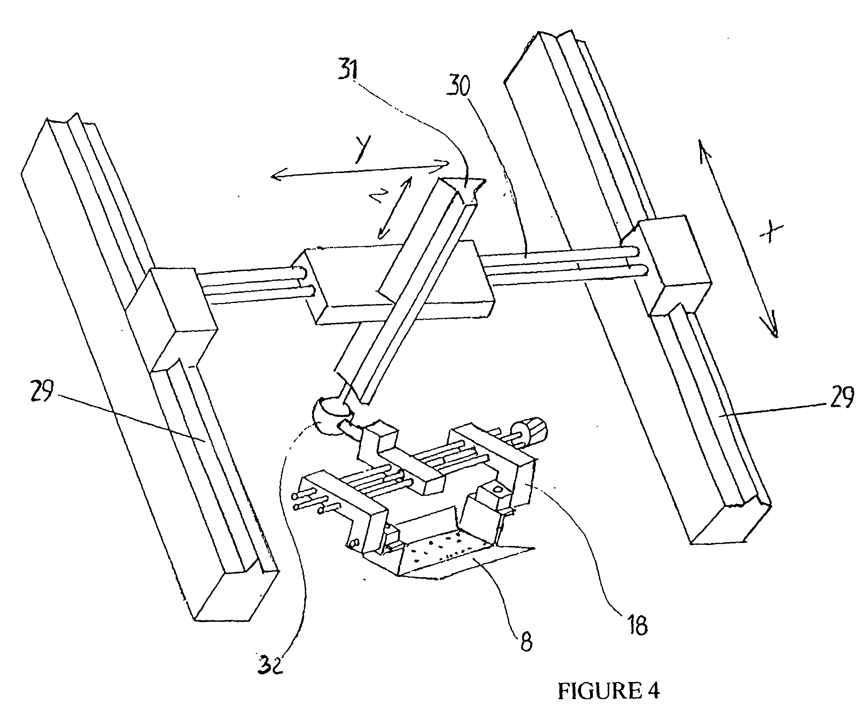

D'autres avantages et caractéristiques de l'invention apparaîtront à la lecture de la description ci-après d'une forme de réalisation de l'invention donnée à titre d'exemple non limitatif et illustré par les dessins joints dans lesquels la figure 3 et la figure 4 représentent deux formes de mise en oeuvre du pochoir selon l'invention.

Selon l'invention, le procédé de réalisation de sérigraphie en des zones déterminées et délimitées d'un substrat quelle que soit la position du substrat fait usage d'un pochoir 8, qui peut être un micro-pochoir et en tous cas de dimensions adaptées à la sérigraphie à réaliser.

Le substrat repéré par la lettre S sur la figure 3 peut être, du fait de sa conformation ou de celle des composants qu'il porte, stable ou stabilisé sur trois points sur la table support.

Dans l'exemple représenté, le substrat S fait un angle ∝ avec la table.

La conformation dans toutes les dimensions de l'environnement de la zone à sérigraphier peut être très diverse. Cette zone peut être bordée, par exemple, par des composants de hauteur telle que cette zone soit difficilement accessible.

Enfin, le substrat peut ne pas être plat mais voilé.
Ce pochoir est un pochoir souple en un matériau synthétique ou métallique qui est tendu sur un élément de mise en tension ou élément tendeur doté de moyens d'écartement de ses branches.

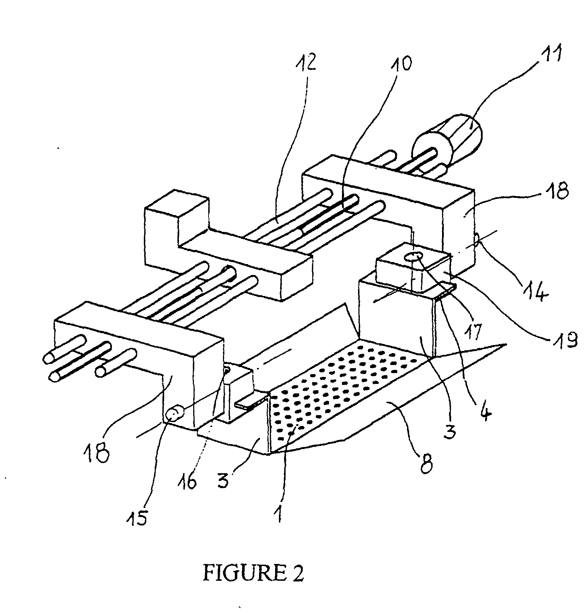

L'élément tendeur représenté en figure 2 comprend un axe de tension 10 avec des moyens de tension 11 permettant l'écartement ou le rapprochement des pattes support 3 et la mise en tension de la feuille 1 entre celles-ci.

Il comprend également un guidage en translation 12 permettant l'écartement du pochoir lorsque l'on agit sur le moyen de tension 11.
Il comprend un axe de rotation gauche 15 parallèle au mini-pochoir et un axe de rotation droite 14 parallèle au mini-pochoir et un axe de rotation gauche 16 perpendiculaire au mini-pochoir et un axe de rotation droite 17 perpendiculaire au mini-pochoir, ces deux axes étant confondus avec des pions de fixation des pattes qui se logent dans le perçage médian de chacune de leurs ailes.

Cette combinaison de rotations permet au pochoir de se mouvoir sur chacune de ses pattes raidisseurs d'une manière indépendante simultanément autour des axes 16/17 perpendiculaires au mini-pochoir et des axes 14/15 parallèles au mini-pochoir en fonction et en relation avec tout effort perpendiculaire au mini-pochoir effectué sur l'ensemble du dispositif.

La figure 2 représente une forme élaborée de l'élément tendeur de feuille 1.
L'axe de tension 10 est constitué par deux vis à pas inversé commandées par la molette 11, le guidage en translation étant obtenu par les tiges 12 parallèles.

L'axe 10 commande l'écartement des bras 18 qui portent les axes de rotation parallèles au mini-pochoir, les axes de rotation gauche et droite perpendiculaires au mini-pochoir étant constitués par des pions enfilés à travers les blocs fendus 19 suspendus aux bras 18 par les axes de rotation parallèles au mini-pochoir.

Les ailes 4 des pattes 3 sont bloquées dans les fentes des blocs par les pions pénétrant dans leur perçage 5 respectif.
Cette combinaison d'axes permet à la fois de tendre le pochoir et de le positionner bien en contact sur le substrat même si celui-ci est voilé.

Selon l'invention, le substrat étant dans une position donnée et quelle que soit cette position l'élément tendeur de pochoir et le pochoir 8 sont portés par un organe mobile et sont amenés et plaqués par l'utilisateur sur ledit substrat à la zone où la sérigraphie est à réaliser et ce quelle que soit la position stable ou stabilisée du substrat ou de la zone du substrat concernée.

Dans la présente invention, le dispositif de mise en oeuvre permet de mouvoir le pochoir ou micro-pochoir dans des amplitudes de mouvements très importantes.

Selon l'invention, le micro-pochoir est bloqué en position sur le substrat pour réaliser la sérigraphie ; le pochoir peut être écarté du substrat pour l'évacuation de celui-ci et/ou son remplacement en pouvant retrouver la position donnée par l'utilisateur et en permettant de la retrouver par déplacement en sens inverse soit de l'élément de mise en tension, soit de l'organe mobile portant le support de pochoir et le pochoir.

Avantageusement, selon l'invention, l'écartement ou le rapprochement de l'élément de mise en tension 18 et du pochoir 8 par rapport au substrat s'effectue suivant une direction orthogonale ou voisine de l'orthogonale par rapport au substrat ce qui facilite le démoulage.

L'élément tendeur et le pochoir peuvent être dégagés du substrat comme énoncé plus haut en retrouvant la position initiale donnée.

Selon l'invention, le blocage du support et du pochoir est obtenu par blocage dans l'espace de l'organe mobile.

La figure 3 illustre une forme de mise en oeuvre de l'invention dans laquelle est représenté sur une table fixe l'élément de mise en tension tel que décrit et le pochoir 8.

L'élément de mise en tension est fixé de manière articulée à l'extrémité d'un organe mobile pouvant se mouvoir dans l'espace constitué par un bras 20 à plusieurs brins 20A, 20B, 20C, 20D, etc..., articulés entre eux ; ledit bras étant fixé par son autre extrémité sur un coulisseau 25 mobile en translation verticale,

Selon une forme préférée de réalisation de l'invention, le bras 20 est un bras à blocage par des moyens hydrauliques connus de ses articulations 21, le blocage étant obtenu par une commande unique . Enfin, à elle seule, l'articulation sphérique 21C confère au bras 20A porte tendeur de pochoir une possibilité d'ajustement très fine du pochoir sur le substrat. Un bras à plusieurs brins avec un blocage mécanique unique 22 peut également être utilisé. Le coulisseau 25 sur lequel est fixé en un point le bras 20 est monté dans un bâti 23, permettant son déplacement suivant Z au moyen d'un levier 24 ; cette disposition permet de déplacer le point fixe et de soulever le pochoir 8 par rapport au substrat posé sur la table 28 suivant un mouvement orthogonal ou voisin de l'orthogonale.

Avantageusement, dans l'exemple de réalisation de l'invention est représentée une racle 26 agissant sur le pochoir et qui peut être commandée par un organe 27 de tout type connu.
Le bras 20 est mobile dans l'espace autour de sa fixation sur le coulisseau et son système d'articulation permet de positionner le pochoir dans toute position suivant les six degrés de liberté du bras.

Suivant une autre forme de réalisation de l'invention non représentée, le bras est monté sur une pièce fixée sur la table et non mobile ou sur la table elle-même et un système de coulisseau du même genre que le coulisseau (25) mobile suivant Z est fixé à l'autre extrémité du bras articulé et porte l'élément de mise en tension (18) et le pochoir (8) pour permettre son écartement en direction orthogonale par rapport au substrat quelle que soit la position du substrat.
Dans ce cas, le déplacement du pochoir est obtenu sans déplacement du bras mobile qui conserve la position que lui confère l'utilisateur en positionnant le pochoir 8 sur le substrat et en bloquant le bras mobile.
Dans ces deux cas, l'organe mobile, en l'espèce le bras articulé 20, conserve la position et il retrouve la position initiale par translation grâce au coulisseau 25.

La figure 4 illustre une autre forme de mise en oeuvre de l'invention dans laquelle est représenté l'élément de mise en tension tel que décrit et le pochoir 8.

L'élément de mise en tension est fixé de manière articulée à l'extrémité d'un organe mobile pouvant se mouvoir selon les six degrés de liberté de l'espace. L'organe mobile se termine par une rotule 32 qui confère la possibilité de mouvoir l'élément de tension et donc le pochoir suivant les trois rotations possibles dans l'espace. Les trois translations dans l'espace suivant X, Y et Z sont respectivement rendues possibles par les glissières 29,30 et 31.
Il est entendu que les 6 mouvements possibles dans l'espace sont blocables de manière à fixer la position de l'élément de mise en tension.

Selon une autre caractéristique de l'invention la glissière 31 du portique peut être déplacée suivant Z de façon indépendante des autres degrés de liberté tout en maintenant les autres mouvements bloqués pour permettre l'écartement du pochoir par rapport au substrat en maintenant le reste de la configuration bloquée.

Le déplacement suivant les six degrés de liberté du tendeur de pochoir et du pochoir peut être soit manuel, soit motorisé et automatisé ; un ou plusieurs organes et moyens de blocage de tout type connu permettent, lorsque le pochoir est en bonne position sur la zone du substrat concernée par la sérigraphie de bloquer le pochoir en position. L'écartement du pochoir suivant Z de manière orthogonale par rapport au substrat permet de réaliser le démoulage et d'enlever le substrat pour le remplacer par un autre.

## Revendications

1. Pochoir associé à son élément de mise en tension et dispositif de mise en oeuvre de l'ensemble ainsi constitué permettant de déposer, par une opération de sérigraphie à l'aide d'une racle (26), de la crème à braser ou du flux ou de la colle conductrice pour la réparation et/ou le remplacement et/ou la pose de composants unitaires ou de groupes de composants sur un substrat (5) **caractérisé en ce que** l'ensemble comprend :
- une feuille plane (1) de forme rectangulaire en matériau synthétique souple ou métallique dotée d'orifices (2) de transfert de produit et de distribution du produit en quantité constante, deux des côtés parallèles de la feuille étant fixés sur des pattes (3) rigides et mobiles en position de fixation sur l'élément de mise en tension, les deux autres côtés parallèles de la feuille étant prolongés par des bavettes souples (6), un pli (7) séparant la feuille et chaque bavette, ledit pli délimitant le côté de la feuille, la bavette étant libre en rotation autour du pli ; et
- l'élément de mise en tension du pochoir et de conformage du pochoir au substrat ; le dispositif de mise en oeuvre de l'ensemble lui permettant de se mouvoir selon les six degrés de liberté dans l'espace.

2. Pochoir associé à son élément de mise en tension et dispositif de mise en oeuvre de l'ensemble ainsi constitué selon la revendication 1 **caractérisé en ce que** les deux pattes (3) du pochoir ainsi que les deux bavettes souples (6) forment des limites physiques qui empêchent les débordements de produit à sérigraphier sur le substrat.

3. Pochoir associé à son élément de mise en tension et dispositif de mise en oeuvre de l'ensemble ainsi constitué selon la revendication 1 **caractérisé en ce que** la feuille plane (1) est un matériau synthétique demi-transparent pour faciliter le positionnement.

4. Pochoir associé à son élément de mise en tension et dispositif de mise en oeuvre de l'ensemble ainsi constitué selon la revendication 1 **caractérisé en ce que** les bavettes (6) sont libres par rapport aux autres côtés de la feuille.

5. Pochoir associé à son élément de mise en tension et dispositif de mise en oeuvre de l'ensemble ainsi constitué selon les revendications 1 et 2 **caractérisé en ce que** la largeur de la racle (26) corresponde à celle de la feuille (1).

6. Pochoir associé à son élément de mise en tension et dispositif de mise en oeuvre de l'ensemble ainsi constitué selon les revendications 1 à 5, le pochoir étant doté sur chacune de ses pattes (3) d'une aile (4) parallèle à la feuille (1) **caractérisé en ce que** le pochoir se fixe par les dites ailes sur ledit élément de mise en tension, lui-même fixé sur le dispositif de mise en oeuvre constitué par un bras (20), ledit élément de mise en tension comprenant :
- un axe de tension (10) parallèle au pochoir;
- un guidage en translation (12);
- des axes de rotation (14,15) de chacune des pattes parallèles au pochoir; et
- des axes de rotation (16,17) de chacune des pattes perpendiculaires au pochoir; le dispositif de mise en oeuvre étant formé par le bras (20) à plusieurs brins articulés et doté d'un moyen de blocage (22) de sa ou de ses articulations (21), ledit bras portant l'élément de mise en tension du pochoir à une extrémité, l'autre extrémité étant fixée sur un support mobile verticalement (25) ; le pochoir pouvant ainsi se mouvoir selon les six degrés de liberté.

7. Pochoir associé à son élément de mise en tension et dispositif de mise en oeuvre de l'ensemble ainsi constitué selon la revendication 6 **caractérisé en ce que** le dispositif de mise en oeuvre constitué par le bras (20) à plusieurs brins articulés est fixé sur le support mobile (25) verticalement pour permettre l'écartement du pochoir par rapport au substrat en maintenant la conformation dans laquelle il est bloqué.

8. Pochoir associé à son élément de mise en tension et dispositif de mise en oeuvre de l'ensemble ainsi constitué selon la revendication 7 **caractérisé en ce que** le dispositif de mise en oeuvre constitué par le bras (20) à plusieurs brins articulés autour d'articulations (21) est blocable en position de travail par le moyen de blocage unique (22).

9. Pochoir associé à son élément de mise en tension et dispositif de mise en oeuvre de l'ensemble ainsi constitué selon les revendications 1 à 5, le pochoir étant doté sur chacune de ses pattes (3) d'une aile (4) parallèle à la feuille (1) **caractérisé en ce que** le pochoir se fixe par les dites ailes sur ledit élément de mise en tension, lui-même fixé sur le dispositif de mise en oeuvre formé par un portique composé de trois glissières (29), (30) et (31) et une liaison rotule (32), ledit portique portant l'élément de mise en tension du pochoir, qui peut donc se mouvoir selon les six degrés de libertés.

10. Pochoir associé à son élément de mise en tension et dispositif de mise en oeuvre de l'ensemble ainsi constitué selon la revendication 9 **caractérisé en ce que** le dispositif de mise en oeuvre constitué par le portique puisse se mouvoir suivant Z selon la glissière (31) tout en maintenant les autres mouvements bloqués pour permettre l'écartement du pochoir par rapport au substrat en maintenant le reste de la configuration bloquée

## Patentansprüche

1. Schablone verbunden mit seinem Spannungselement und Anwendung-Vorrichtung für die Gesamtheit, um durch eine Druck Operation mit einer Rakel (26), Lötpaste, Flux oder leitender Klebstoff aufzubringen, um auf einem Substrat (S) einzelne oder mehrere Bauelemente zu reparieren und/oder wechseln und/oder montieren, **dadurch gekennzeichnet, daß** es folgendes umfasst:
- Eine aus Kunststoff oder Metal ebene, rechteckige Folie (1) die mit Transfer-Öffnungen versehen ist um das Produkt in gleichmäßigen Mengen zu verteilen, zwei von den gleichlaufenden Seiten dieser Folie sind mit festen und bewegbaren Befestigungsklammern (3) am Spannungselementverbunden, die zwei anderen Seiten mit einer flexiblen Wandung (6) verlängert, eine Falte (7) trennt die Folie und jede Wandung diese bleiben bewegungsfrei um der Falte :
- Das Schablone Spannungs-und Substrat Übereinstimmungs-Element und die Anwendungs-Einrichtung die eine Bewegung, nach den sechs Bewegungsmöglichkeiten im Weltraum erlaubt.

2. Schablone verbunden mit seinem Spannungselement und Anwendung-Vorrichtung für die Gesamtheit nach Anspruch 1, **dadurch gekennzeichnet, daß** die zwei flexible Wandungen (6) Begrenzungen bilden gegen das Überfließen vom Druckprodukt.

3. Schablone verbunden mit seinem Spannungselement und Anwendung-Vorrichtung für die Gesamtheit nach Anspruch 1, **dadurch gekennzeichnet, daß** die Folie (1), aus einem halb durchsichtigen Kunststoff besteht um das Positionieren zu erleichtern.

4. Schablone verbunden mit seinem Spannungselement und Anwendung-Vorrichtung für die Gesamtheit nach Anspruch 1, **dadurch gekennzeichnet, daß** die Wandungen (6) von den Folienseiten frei sind.

5. Schablone verbunden mit seinem Spannungselement und Anwendung-Vorrichtung für die Gesamtheit nach Ansprüche 1 und 2, **dadurch gekennzeichnet, daß** die Breite der Rakel (26) und der Folie (1) gleich sind.

6. Schablone verbunden mit seinem Spannungselement und Anwendung-Vorrichtung für die Gesamtheit nach Ansprüche 1 bis 5, die Schablone ist auf jeder Befestigungsklaue (3) mit einem Flügel (4) ausgestattet der gleichlaufend ist mit der Folie (1), darduch **gekennzeichnet**, daß die Schablone durch diese Flügel auf dem Spannungselementbefestigt ist, dasjenige selbst auf der Anwendung-Vorrichtung die aus einem Arm (20) besteht befestigt ist. Das Spannungselement besteht aus:
- Einer Spannungs-Achse (10) gleichlaufend mit der Schablone,
- Einer Führung (12),
- Drehungs-Achsen (14, 15) für die Befestigungsklauen gleichlaufend mit der Schablone,
Die Anwendung-Vorrichtung besteht aus einem Arm (20) mit mehreren gegliederten Strängen, mit einem für eine/oder jede Gliederung (21) Blockiersystem (22) versehen ist, der Arm trägt an einem Ende das Schablone Spannungselement, und ist am andere Ende senkrecht an der Stütze (25) fixiert ; die Schablone kann sich derart nach den sechs Bewegungs-Möglichkeiten im Weltraum bewegen.

7. Schablone verbunden mit seinem Spannungselement und Anwendung-Vorrichtung für die Gesamtheit nach Anspruch 6, **dadurch gekennzeichnet daß** die Anwendung-Vorrichtung die aus dem Arm (20) mit mehreren gegliederten Strängen versehen und auf einer senkrechte bewegbare Stütze (25) fixiert ist, um die Entfernung der Schablone vom Substrat zu erlauben, indem die Bildung wo er blockiert ist behalten wird.

8. Schablone verbunden mit seinem Spannungselement und Anwendung-Vorrichtung für die Gesamtheit nach Anspruch 7, **dadurch gekennzeichnet daß** die Anwendung-Vorrichtung die aus dem Arm (20) mit mehreren Strängen beweglich um die Gliederungen (21) versehen ist in Arbeitsposition durch ein einziges Blockiersystem (22) blockierbar ist.

9. Schablone verbunden mit seinem Spannungselement und Anwendung-Vorrichtung für die Gesamtheit nach Ansprüche 1 bis 5, die Schablone hat auf jeder Befestigungsklaue (3) ein Flügel (4) der gleichlaufend mit der Folie (1) ist, **dadurch gekennzeichnet daß**, die Schablone durch diese Flügel auf dem Spannungselement befestigt ist, dasjenige selbst auf der Anwendungs-Vorrichtung durch ein aus drei Überführungen (29), (30), (31) und ein Kugelgelenk (32) bestenhendes Turmgerüst fixiert ist. Das Turmgerüst trägt das Schablone Spannungselement, Die Schablone kann sich derart nach den sechs Bewegungs-Möglichkeiten im Weltraum bewegen.

10. Schablone verbunden mit seinem Spannungselement und Anwendung-Vorrichtung für die Gesamtheit nach Anspruch 9, **dadurch gekennzeichnet daß** die aus dem Turmgerüst bestehende Anwendungs-Vorrichtung nach Z über die Führungen (31) bewegbar ist indem die anderen Bewegegung blockiert sind um die Entfernung der Schablone vom Substrat zu erlauben und indem der Rest der Bildung blockiert ist.

## Claims

1. Stencil and devices for its operation and tensioning , allowing to deposit through a printing operation with a scraper (26) solder paste, flux or conductive adhesive to repair and/or replace and/or place unit or group constituents on a substrate (s), **characterized by** the fact that it consists of:
- a flat sheet (1), of rectangular shape, made of synthetic flexible material or metal, outfitted with transfer openings (2) for distributing a product at a constant amount, two of the parallel sides of the sheet are affixed to rigid and mobile tabs (3) attached onto a tension unit, the other two parallel sides of the sheet are extended with flexible flaps (6), a fold (7) separating the sheet from each flap, said fold delimiting the side of the sheet, the wall being free to rotate around the fold;
- the tension unit for the stencil allows it to conform to the substrate ; the joint part to operate the stencil in space, in space, in accordance with six degrees of freedom.

2. Stencil and devices for its operation and tensioning in accordance with claim 1, **characterized by** the fact that the tabs (3) and the flexible flaps (6) are forming physical limits to avoid the overflowing of products to be printed onto the substrate.

3. Stencil and devices for its operation and tensioning in accordance with claim 1, **characterized by** the fact that the flat sheet (1) consists of semi-transparent synthetic material facilitating positioning.

4. Stencil and devices for its operation and tensioning in accordance with claim 1, **characterized by** the fact that the flaps (6) are free as opposed to the other sides of the sheet.

5. Stencil and devices for its operation and tensioning in accordance with claims 1 and 2 **characterized by** the fact that the length of the scraper (26) corresponds to that of the sheet (1).

6. Stencil and devices for its operation and tensioning in accordance with claim 1 through 5, the stencil having on each of its tabs (3) a wing (4) parallel to the sheet (1), **characterized by** the fact that the stencil is affixed by the said wings onto the said tension unit, the last being mounted on an operational unit constituted by an arm (20), said tensioning device comprising :
- a tension axle (10) parallel to the stencil,
- a displacement control (12),
- rotation axles (14/15) of each tab parallel to the stencil, and
- rotation axles (16/17) of each tab perpendicular to the stencil,
the operational device consisting of arm (20) with several jointed strands with a locking means (22) of its joint or joints (21), said arm bearing the part on which the stencil is stretched at one end, the other end being attached on a support which moves vertically (25), the stencil thus able to move in accordance with six degrees of freedom.

7. Stencil and devices for its operation and tensioning in accordance with claim 6 **characterized by** the fact that the operational part consists of arm (20), with several jointed strands, which is affixed to the vertically mobile support (25) to allow the stencil to move away from the substrate while maintaining the configuration in which it is locked.

8. Stencil and devices for its operation and tensioning in accordance with claim 7, **characterized by** the fact that the operational part consists of arm (20) with several jointed strands around rotation axles (21), lockable in a work position by means of a sole locking (22).

9. Stencil and devices for its operation and tensioning in accordance with claim 1 through 5, the stencil having on each of its tabs (3) a wing (4) parallel to the sheet (1), **characterized by** the fact that the stencil is affixed by the said wings onto the said tension unit, the last being mounted on an operational unit forming a gate comprising three sliding rails (29), (30) and (31), and a gooseneck (32), said gate bearing the element on which the stencil is stretched, which can move in accordance with six degrees of freedom.

10. Stencil and devices for its operation and tensioning in accordance with claim 9, **characterized by** the fact that the operational device consisting of the gate can move in a Z fashion along slide rail (31) while keeping the other movements locked to allow the stencil to move away from the substrate while maintaining the rest of the configuration locked.
